# FASCICULE DE BREVET EUROPEEN

(11) **EP 2 655 491 B1**
(45) Date de publication et mention de la délivrance du brevet: **16.05.2018**
(21) Numéro de dépôt: 11797262.0
(22) Date de dépôt: 20.12.2011
(51) Int. Cl.: C08K 7/14, C23C 16/50, C08J 7/04, C08J 7/12, C08J 7/18, C08K 5/00

(54) **ARTICLE IGNIFUGE À BASE DE POLYAMIDE COMPRENANT UN REVÊTEMENT PAR TRAITEMENT PLASMA**
FEUERFESTER POLYAMIDARTIKEL MIT EINER ANHAND VON PLASMABEHANDLUNG HERGESTELLTEN BESCHICHTUNG
FIREPROOF POLYAMIDE ARTICLE INCLUDING A COATING FORMED BY PLASMA TREATMENT

(30) Priorité: 21.12.2010 FR 1060871
(43) Date de publication de la demande: 30.10.2013
(73) Titulaire: Rhodia Operations, 93306 Aubervilliers (FR)
(72) Inventeur: GADOU, Hélène, F-62980 Vermelles (FR); JIMENEZ, Maude, F-59000 Lille (FR); JAMA, Charafeddine, F-59650 Villeneuve D'ascq (FR); DELOBEL, René, F-59650 Villeneuve D'ascq (FR)
(74) Mandataire: Schuck, Alexander
(86) Numéro de dépôt international: PCT/EP2011/073419
(87) Numéro de publication internationale: WO 2012/084955

(56) Documents cités:
- WO-A1-2004/055103
- HORROCKS A R ET AL: "Surface modification of fabrics for improved flash-fire resistance using atmospheric pressure plasma in the presence of a functionalized clay and polysiloxane", POLYMERS FOR ADVANCED TECHNOLOGIES, WILEY & SONS, BOGNOR REGIS, GB, vol. 22, no. 1, 26 avril 2010 (2010-04-26) , pages 22-29, XP007916592, ISSN: 1042-7147, DOI: 10.1002/PAT.1707 [extrait le 2010-04-26]
- JAMA C ET AL: "Fire retardancy and thermal stability of materials coated by organosilicon thin films using a cold remote plasma process", WATER-SOLUBLE POLYMERS: SYNTHESIS, SOLUTION PROPERTIES AND APPLICATIONS, AMERICAN CHEMICAL SOCIETY, WASHINGTON, DC, US, vol. 797, 20 août 2000 (2000-08-20), pages 200-213, XP009029768, ISBN: 978-0-541-23408-9
- GILMAN J W ET AL: "Nanocomposites: A revolutionary new flame retardant approach", SAMPE JOURNAL, AZUSA, CA, US, vol. 33, no. 4, 1 janvier 1997 (1997-01-01), pages 40-46, XP009029920, ISSN: 0091-1062

## Description

La présente invention concerne des articles, notamment des articles moulés, ignifugés à base de polyamide comprenant un revêtement déposé en utilisant un plasma froid. Ces articles, présentant d'excellentes propriétés d'ignifugation, comprennent dans la matrice polyamide au moins un système d'ignifugation, et présentent un tel revêtement sur au moins une des surfaces desdits articles.

### ART ANTERIEUR

Les compositions à base de résine polyamide sont utilisées pour la réalisation d'articles par différents procédés de mise en forme, notamment des articles moulés de diverses manières. Ces articles sont utilisés dans de nombreux domaines techniques. Parmi ceux-ci la réalisation de pièces de systèmes électriques ou électroniques est une application importante requérant des propriétés particulières. Ainsi, ces pièces doivent présenter des propriétés mécaniques élevées mais également des propriétés de résistance chimique, d'isolation électrique et surtout une résistance au feu élevée.

Le retard à la flamme peut être réalisé en appliquant un revêtement à base de silicone sur la surface des substrats polymériques. Ainsi, Jama et al., « Fire Retardancy and Thermal Stability of Materials Coated by Organosilicon Thin Films Using a Cold Remote Plasma Process », Nelson and Wilkie, Fire and Polymers, ACS Symposium Series, American Chemical Society, Washington, DC, 2001, pages 200-213, décrit la stabilité thermique de films fins obtenus par la polymérisation du monomère 1,1,3,3-tétraméthyldisiloxane (TMDS) dopé avec de l'oxygène en utilisant le procédé CRNP (cold remote nitrogen plasma). Ce procédé est utilisé pour déposer des films fins sur des substrats de polyamide 6 et des substrats de nanocomposites de polyamide 6 et d'argile.

WO 2004/055103 décrit, quant à lui, un composite polymère résistant à la flamme comprenant un substrat polymère; un retardateur de flamme inter-mélangé avec le substrat polymère; et une couche organosiliciée polymérisée par plasma, partiellement oxydée et adhérant au substrat. Le composite résistant à la flamme peut facilement atteindre une évaluation V-0 dans un test d'inflammabilité UL-94 en utilisant une concentration de retardateur de flamme sensiblement inférieure à celle habituellement incorporée dans les substrats pour obtenir le même résultat.

Par ailleurs, Horrocks et al., "Surface modification of fabrics for improved flash-fire résistance using atmospheric pressure plasma in the presence of a functionalized clay and polysiloxane", Polym. Adv. Technol., 2011, Vol. 22, pages 22-29 décrit la modification de surface de tissus pour améliorer la résistance au feu, au moyen d'un plasma à pression atmosphérique, en présence d'une argile fonctionnalisée et de polysiloxane et Gilman et al., «Nanocomposites: A revolutionary new flame retardant approach », SAMPE Journal, Vol. 33, No. 4, Juillet/Août 1997, pages 40-46, décrit les propriétés d'inflammabilité de nanocomposites de nylon 6 et d'argile.

L'ignifugation des compositions à base de résine polyamide a été étudiée depuis très longtemps. Ainsi, les ignifugeants principaux utilisés sont le phosphore rouge et, des composés halogénés tels que les dibromophénols, les polybromodiphényles, les polybromodiphényloxydes, et les polystyrènes bromés. Depuis une vingtaine d'années de nouvelles classes d'ignifugation ont été développées, telles que des composés organiques azotés appartenant à la classe des triazines telles que la mélamine ou ses dérivés comme le cyanurate de mélamine et plus récemment les phosphates, polyphosphates, pyrophosphates de mélamine, seuls ou en association avec des phosphonates ou des phosphinates organiques et/ou inorganiques.

L'avantage de cette dernière classe d'ignifugeants réside dans le fait que les composés concernés ne contiennent pas d'halogènes ni de phosphore rouge. En effet, les ignifugeants contenant des halogènes ou du phosphore rouge peuvent générer des gaz toxiques lors de la combustion de la composition polyamide, ou même durant l'élaboration de ladite composition. Toutefois, les quantités de certains composés à base de mélamine nécessaires pour obtenir une ignifugation satisfaisante sont très élevées, notamment pour les compositions contenant des charges de renfort sous forme de fibres telles que les fibres de verre. Cette concentration élevée en composés de mélamine présente certains inconvénients notamment pendant la fabrication de la composition, tels que la production de vapeur des composés mélaminés, ou pendant la production des articles moulés, tels que l'obstruction des conduits de ventilation et des dépôts dans les moules.

De même, les nouveaux systèmes ignifugeants phosphorés organiques ont un coût élevé et ont besoin d'être utilisés en grande quantité pour obtenir de bonnes propriétés d'ignifugation.

Une trop forte quantité d'agents ignifugeants dans une matrice polyamide conduit par ailleurs à une diminution de ses propriétés mécaniques. Or, certaines applications, et par exemple des applications de structure, nécessitent des propriétés mécaniques élevées associées à de bonnes propriétés d'ignifugation.

Il existe ainsi un besoin de préparer des compositions polyamides ignifugées comprenant des teneurs en agents ignifugeants, notamment les composés organo-phosphorés, relativement faibles, ou en tout cas significativement plus faibles que la teneur habituellement utilisée pour obtenir une bonne capacité d'ignifugation.

### INVENTION

La demanderesse a mis en évidence de manière tout à fait inattendue qu'il était possible de réaliser des articles polyamides présentant d'excellentes propriétés d'ignifugation, tout en utilisant de faibles quantités d'agents ignifugeants, en effectuant un revêtement sur lesdits articles polyamides par dépôt chimique assisté par plasma froid.

La présente invention a ainsi pour objet un article ignifugé tel que défini à la revendication 1, obtenu par mise en forme d'une composition polyamide comprenant au moins un système d'ignifugation ; ledit article comprenant au moins sur une partie de sa surface un revêtement produit par dépôt chimique assisté par plasma froid, tout particulièrement lesdits articles conduisent à un résultat V0 au test UL94, sur barreaux de 1,6 mm.

On obtient ainsi des articles polyamides présentant une très bonne ignifugation et notamment un résultat V0 au test UL94 tout en utilisant de faibles quantités d'agents ignifugeants et ainsi obtenir de bonnes propriétés mécaniques ; par la présence d'un revêtement par dépôt chimique assisté par plasma sur lesdits articles polyamides. Un tel revêtement permet en effet de conférer aux articles de bonnes propriétés d'ignifugation et ne contient pas de composés néfastes pour l'environnement dans les produits de combustion, ces derniers étant généralement constitués par des matériaux de type silice.

On entend par surface la couche superficielle d'un article polyamide selon l'invention. Une surface est généralement une portion délimitée par une frontière ou des limites. Une surface peut être notamment plane, concave et/ou convexe selon les articles et leur complexité.

L'article selon l'invention est obtenu par mise en forme d'une composition à base de polyamide ; c'est-à-dire comprenant au moins un polyamide.

Le polyamide est choisi dans le groupe comprenant les polyamides obtenus par polycondensation d'un diacide carboxylique linéaire avec une diamine linéaire ou cyclique comme le PA 6.6, PA 6.10, PA 6.12, PA 12.12, PA 4.6, MXD 6 ou entre un diacide carboxylique aromatique et une diamine linéaire ou aromatique comme les polytéréphtalamides, polyisophtalamides, polyaramides, les polyamides obtenus par polycondensation d'un aminoacide sur lui-même, l'amino-acide pouvant être généré par l'ouverture hydrolytique d'un cycle lactame tels que, par exemple PA 6, PA 7, PA 11, PA 12.

La composition de l'invention peut également comprendre les copolyamides dérivés notamment des polyamides ci-dessus, ou les mélanges de ces polyamides ou copolyamides.

Les polyamides préférés sont le polyhexaméthylène adipamide, le polycaprolactame, ou les copolymères et mélanges entre le polyhexaméthylène adipamide et le polycaprolactame.

On utilise généralement des polyamides de masses moléculaires adaptées aux procédés de moulage par injection, bien que l'on puisse utiliser aussi des polyamides de plus faibles viscosités. On peut également utiliser des polyamides de plus hautes masses moléculaires notamment pour ce qui concerne des procédés de transformation de type extrusion ou extrusion-soufflage.

La matrice polyamide peut notamment être un polymère comprenant des chaînes macromoléculaires étoiles ou H, et le cas échéant des chaînes macromoléculaires linéaires. Les polymères comprenant de telles chaînes macromoléculaires étoiles ou H sont par exemple décrits dans les documents FR 2743077, FR 2779730, US 5959069, EP 0632703, EP 0682057 et EP 0832149.

Selon une autre variante particulière de l'invention, la matrice polyamide de l'invention peut être un polymère de type arbre statistique, de préférence un copolyamide présentant une structure arbre statistique. Ces copolyamides de structure arbre statistique ainsi que leur procédé d'obtention sont notamment décrits dans le document WO 99/03909. La matrice de l'invention peut également être une composition comprenant un polymère thermoplastique linéaire et un polymère thermoplastique étoile, H et/ou arbre tels que décrits ci-dessus. La matrice de l'invention peut également comprendre un copolyamide hyperbranché du type de ceux décrits dans le document WO 00/68298. La composition de l'invention peut également comprendre toute combinaison de polymère thermoplastique linéaire, étoile, H, arbre, copolyamide hyperbranché tel que décrit ci-dessus.

La composition selon l'invention peut comprendre entre 20 et 99 % en poids, préférentiellement entre 20 et 80 % en poids, plus préférentiellement entre 50 et 70 % en poids, de polyamide, par rapport au poids total de la composition.

La matrice de la composition peut également comprendre, outre le polyamide, un ou plusieurs autres polymères, notamment des polymères thermoplastiques.

La composition comprend des charges de renfort choisies dans le groupe comprenant les charges fibreuses que sont les fibres de verre, les fibres de carbone, et les fibres organiques.

La concentration pondérale des charges de renfort peut être comprise avantageusement entre 1 % et 50 % en poids par rapport au poids total de la composition, de préférence entre 15 et 50 %. On peut notamment utiliser un mélange de fibres de verre et de charges minérales, telle que de la wollastonite.

Tout particulièrement, la composition comprend un ratio pondéral charges fibreuses / charges totales allant de 0,7 à 1, en particulier de 0,9 à 1, tout particulièrement de 0,95 à 1.

Tout particulièrement, la composition comprend une teneur en charges fibreuses, notamment en fibres de verre, fibres de carbone et/ou fibres organiques, et en particulier en fibres de verre, allant de 10 à 50 % en poids, notamment de 15 à 50 % en poids par rapport au poids total de la composition.

Les compositions de l'invention peuvent également comprendre tous les additifs habituellement utilisés dans les compositions à base de polyamide utilisées pour la fabrication d'articles moulés. Ainsi, on peut citer à titre d'exemple d'additifs les stabilisants thermiques, stabilisants U.V., antioxydants, lubrifiants, pigments, colorants, plastifiants ou des agents modifiant la résistance aux chocs. A titre d'exemple, les antioxydants et stabilisants chaleur sont, par exemple, des halogénures d'alcalins, des halogénures de cuivre, des composés phénoliques stériquement encombrés, des amines aromatiques. Les stabilisants U.V. sont généralement des benzotriazoles, des benzophénones ou des HALS.

Il n'y a pas de limitation aux types d'agents modifiants la résistance aux chocs. Ce sont généralement des polymères d'élastomères qui peuvent être utilisés à cet effet. Des exemples d'élastomères convenables sont les éthylène-ester acrylique-anhydride maléique, les éthylène-propylène-anhydride maléique, les EPDM (éthylène-propylène-diène monomère) avec éventuellement un anhydride maléique greffé. La concentration pondérale en élastomère est avantageusement comprise entre 0,1 et 15 % par rapport au poids total de la composition.

Les compositions de l'invention sont obtenues par mélange des différents constituants généralement dans une extrudeuse mono ou bivis, à une température suffisante pour maintenir la résine polyamide en milieu fondu. Généralement, le mélange obtenu est extrudé sous forme de joncs qui sont coupés en morceaux pour former des granulés. Les agents ignifugeants peuvent être ajoutés ensemble ou séparément, au polyamide par mélange à chaud ou à froid.

L'addition des composés et des additifs peut être réalisée par ajout de ces composés dans le polyamide fondu sous forme pure ou sous forme de mélange concentré dans une résine telle que par exemple une résine polyamide.

Les granulés obtenus sont utilisés comme matière première pour alimenter les procédés de fabrication d'articles tels que les procédés d'injection, de moulage par injection, d'extrusion et d'extrusion-soufflage. L'article selon l'invention peut notamment être un article extrudé ou injecté.

Ainsi, la composition de l'invention convient particulièrement pour la fabrication d'articles utilisés dans le domaine de la connectique électrique ou électronique tels que les éléments de disjoncteurs, interrupteurs, connecteurs ou analogues.

Le système d'ignifugation selon la présente invention comprend au moins un agent ignifugeant, c'est à dire des composés permettant de diminuer la propagation de la flamme et/ou ayant des propriétés d'ignifugation, bien connus de l'homme du métier (ces agents ignifugeants sont habituellement utilisés dans des compositions ignifugées et sont notamment décrits, par exemple, dans les brevets US6344158, US6365071, US6211402 et US6255371, cités ici à titre de référence), contenant du phosphore choisi dans le groupe constitué par les acides phosphiniques ou leurs sels, tels que par exemple les sels d'acides phosphiniques de zinc, de magnésium, de calcium, d'aluminium, ou de manganèse, notamment le sel d'aluminium de l'acide diéthylphosphinique ou le sel de zinc de l'acide diméthylphosphinique.

Avantageusement, le système d'ignifugation peut comprendre en outre au moins un agent ignifugeant choisi parmi le groupe comprenant :
* les agents ignifugeants contenant du phosphore, tels que :
   - les oxydes de phosphines comme par exemple l'oxyde de triphénylphosphine, l'oxyde de tri-(3-hydroxypropyl) phosphine et l'oxyde de tri-(3-hydroxy-2-méthylpropyl) phosphine.
   - les acides phosphoniques ou leurs sels.
   - les phosphonates cycliques, tels que les esters de diphosphate cyclique tel que par exemple l'Antiblaze 1045.
   - les phosphates organiques, tels que le triphénylphosphate.
   - les phosphates inorganiques, tels que les polyphosphates d'ammonium et les polyphosphates de sodium.
   - le phosphore rouge, qu'il soit par exemple sous forme stabilisé ou revêtu, en poudre ou sous forme de masterbatches.
* les agents ignifugeants de type composés organiques azotés tels que par exemple les triazines, l'acide cyanurique et/ou isocyanurique, la mélamine ou ses dérivés comme le cyanurate de mélamine, l'oxalate, le phtalate, le borate, le sulfate, le phosphate, polyphosphate et/ou pyrophosphate de mélamine, les produits condensés de la mélamine, tel que le mélem, le mélam et le mélon, le tris(hydroxyéthyl) isocyanurate, la benzoguanamine, la guanidine, l'allantoïne, et le glycoluril.
* les agents ignifugeants contenant des dérivés halogénés, tels que :
   - les dérivés du brome tels que par exemple les PBDPO (polybromodiphényloxydes), le BrPS (polystyrène bromé et polybromostyrène), le poly(pentabromobenzylacrylate), l'indane bromé, le tétradécabromodiphénoxybenzène (Saytex 120), l'éthane-1,2-bis(pentabromophényl) ou Saytex 8010 d'Albemarle, le tétrabromobisphénol A et les oligomères époxy bromés. Notamment parmi les dérivés bromés, nous pouvons citer le polydibromostyrène tel que le PDBS-80 de Chemtura, les polystyrènes bromés tels que le Saytex HP 3010 d'Albemarle ou le FR-803P de Dea Sea Bromine Group, le décabromodiphényléther (DBPE) ou FR-1210 de Dea Sea Bromine Group, l'octabromodiphényléther (OBPE), le 2,4,6-Tris(2,4,6-tribromophénoxy)-1,3,5 triazine ou FR-245 de Dead Sea Bromine Group, le Poly(pentabromobenzylacrylate) ou FR-1025 de Dead Sea Bromine Group et les oligomères ou polymères à terminaisons époxy du tétrabromobisphénol-A comme tels que les F-2300 et F2400 de Dead Sea Bromine Group.
   - les composés chlorés, tel que par exemple un composé cycloaliphatique chloré comme le Dechlorane plus® (vendu par OxyChem, voir CAS 13560-89-9).

Ces composés peuvent être utilisés seuls ou en combinaison, parfois synergique. On préfère notamment une association synergique de composés contenant du phosphore choisi dans le groupe constitué par les acides phosphiniques ou leurs sels avec des dérivés azotés tels que le mélam, le mélem, le phosphate de mélamine, les polyphosphates de mélamine, les pyrophosphates de mélamine ou les polyphosphates d'ammonium.

La composition peut comprendre de 5 à 40 % en poids d'agents ignifugeants, par rapport au poids total de la composition.

Dans le cadre de l'utilisation des agents ignifugeants contenant du phosphore, tels que les acides phosphiniques ou leurs sels, la composition peut comprendre de 5 à 20 % en poids d'agents ignifugeants, par rapport au poids total de la composition, plus préférentiellement de 5 à 10 % en poids.

Le revêtement de dépôt chimique assisté par plasma froid consiste à faire réagir chimiquement dans un plasma des espèces actives pour donner, au contact de la surface d'un substrat, un produit de réaction solide constituant un revêtement. Cette technique permet l'obtention de dépôts à des températures relativement basses et les processus chimiques sont contrôlés par la cinétique des réactions.

Le revêtement du dépôt chimique assisté par plasma selon l'invention peut être réalisé de diverses manières connues de l'homme du métier, notamment par des techniques de polymérisation assistée par plasma froid, par exemple sous pression réduite ou atmosphérique.

Le plasma froid permet l'obtention de dépôts à des températures comprises entre 20°C et 350°C.

Le plasma, également appelé « quatrième état de la matière » est un milieu macroscopiquement neutre, soumis à une forte énergie d'excitation. C'est un gaz constitué de particules chargés, électrons et ions positifs, qui vont réagir à la surface des matériaux. On distingue principalement deux catégories de plasma : les plasmas thermiques ou chauds qui sont à l'équilibre thermodynamique et les plasmas froids hors équilibre qui sont générés à basse pression présentant un plus faible taux d'ionisation. Les ions qui frappent la surface d'un article transportent de l'énergie sous forme cinétique, vibrationnelle ou électronique et l'énergie d'ionisation est dissipée à la surface par neutralisation ce qui se traduit par une production de radicaux ou de chaleur.

Une des techniques utilisant le plasma froid est la PECVD -dépôt en phase vapeur assistée par plasma- (Plasma Enhanced Chemical Vapour Déposition) qui permet la polymérisation contrôlée par plasma froid en écoulement d'azote d'un gaz plasmagène ou précurseur.

Cette technique permet l'obtention d'une couche mince en surface d'un substrat, fortement réticulée avec une bonne adhérence. Plusieurs techniques de dépôt issues de la PECVD sont possibles selon la position du substrat par rapport à la décharge, telle que notamment la polymérisation assistée par post-décharge. Les espèces réactives, avec une longue durée de vie, sont créées dans la décharge puis se déplacent dans la chambre de réaction jusqu'au substrat. La séparation entre la zone de décharge et le porte-échantillon améliore le contrôle de la formation du film sur le substrat. La zone de post-décharge contient des atomes, des radicaux libres et des molécules dans différents états d'excitation avec une longue durée de vie.

La PECVD peut être modélisée par une suite d'étapes élémentaires :
- création d'espèces réactives dans une décharge (ionisation, dissociation ...)
- transport des espèces réactives de la source au substrat
- adsorption des réactifs à la surface
- réaction et croissance du film
- désorption et évacuation des produits de réaction

Le dépôt assisté par plasma froid présente une structure inorganique de type SiO₂, et/ou une structure organique de type siloxane et/ou polysiloxane, comprenant notamment divers motifs tels que des motifs M, D, et/ou T, selon la pression, la puissance ou proportion d'organosilicés utilisés.

Les composés utilisés pour effectuer le revêtement produit par dépôt chimique assisté par plasma froid sont préférentiellement choisis dans le groupe constitué par : le tétraméthyldisiloxane (TMDSO), l'héxaméthyldisolixane (HDMSO), l'octaméthylcyclotétrasiloxane (OMCTS), et/ou le tétraethoxysilane (TEOS).

Les résultats de l'étude spectroscopique en phase gaz, les analyses spectroscopiques infrarouge et Raman du film ainsi que la détermination de la vitesse de croissance permettent de proposer un mécanisme en trois étapes : une étape d'initiation, une étape de propagation et une étape de terminaison.

Le revêtement à la surface de l'article peut présenter une épaisseur comprise entre 1 et 200 µm, préférentiellement entre 8 et 20 µm.

Les revêtements organo-silicés sont appliqués sur au moins une partie de la surface de l'article selon l'invention. On appliquera notamment le revêtement sur les parties de la surface qui seront susceptibles d'être en contact avec de fortes chaleurs, notamment les flammes ou des parties électriques en fonctionnement et dégageant de fortes chaleurs.

On préfère également uniquement procéder à l'utilisation d'un ou plusieurs revêtements au plasma, notamment sans utiliser un autre type de revêtement.

La présente invention concerne aussi un procédé de fabrication d'article ignifugé dans lequel on applique un revêtement par dépôt chimique assisté par plasma froid sur au moins une partie de la surface de l'article, après avoir éventuellement conduit une étape de traitement de la surface pour accroitre l'adhésion entre la surface et le revêtement.

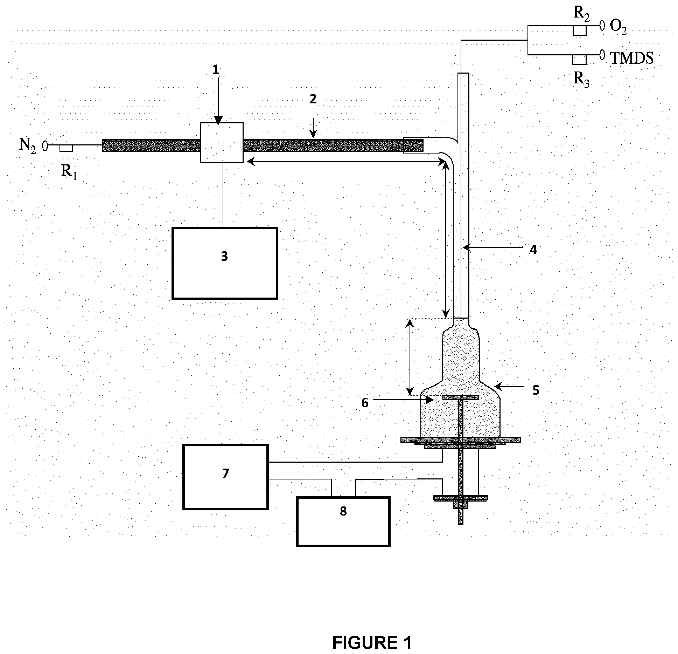

La FIGURE 1 représente le schéma du dispositif du plasma post-décharge. Le générateur micro-onde 3, par l'intermédiaire d'un coupleur coaxial 1, crée le plasma de décharge dans le tube en quartz 2. La pompe 7 permet d'extraire le gaz contenant les espèces excitées de la zone de décharge vers la zone de post-décharge lointaine par l'injecteur tubulaire coaxial 4 vers le réacteur 5. Les gaz réactifs - le monomère TMDSO et l'oxygène - sont introduits dans le réacteur 5 en pyrex (hauteur 600 mm et diamètre 300 mm). L'extrémité de l'injecteur est située à 200 ou 250 mm du substrat et à 650 mm de la décharge. Le porte-substrat circulaire 6, en aluminium, a un diamètre de 150 mm. L'oxygène et le TMDSO ont leurs débit maintenus constants grâce à des régulateurs de débit massique MKS.

La pression à l'intérieur de l'enceinte réactionnelle est mesurée à l'aide d'une jauge de pression de type Pirani.

Un langage spécifique est utilisé dans la description de manière à faciliter la compréhension du principe de l'invention. Il doit néanmoins être compris qu'aucune limitation de la portée de l'invention n'est envisagée par l'utilisation de ce langage spécifique. Des modifications, améliorations et perfectionnements peuvent notamment être envisagés par une personne au fait du domaine technique concerné sur la base de ses propres connaissances générales.

Le terme et/ou inclut les significations et, ou, ainsi que toutes les autres combinaisons possibles des éléments connectés à ce terme.

D'autres détails ou avantages de l'invention apparaîtront plus clairement au vu des exemples donnés ci-dessous uniquement à titre indicatif.

### PARTIE EXPERIMENTALE

### Matériels utilisés

Les essais ont été effectués avec les constituants suivants :
- polyamide 6,6,
- fibres de verre (Vetrotex 983), notés FV,
- phosphinate d'aluminium (OP 1230 de Clariant), noté OP1230, et
- nanocharges de type montmorillonite, notés nanocharges.

Les teneurs en ces constituants sont présentées dans le tableau 2 ci-après.

Différents types d'articles sont obtenus selon les tests ultérieurs à effectuer par moulage par injection.

### Procédure de dépôt

Une PECVD dont le schéma est représenté à la Figure 1 est effectuée avec les paramètres suivants échelonnés sur deux niveaux, un niveau inférieur et un niveau supérieur, et en utilisant comme composé organosilicé le TMDSO :

**Tableau 1**

| **Paramètres** | |
|---|---|
| Puissance du générateur micro-ondes (Watts) | 1000 |
| Débit O₂ (mL/min) | 150 |
| Débit N₂ (mL/min) | 4500 |
| Débit TDMSO (mL/min) | 15 |
| Distance injecteur-substrat (mm) | 200 |
| Temps de prétraitement (min) | 10 |
| Temps de traitement (min) | 40 |

On obtient à la surface de l'article polyamide un film organique d'une épaisseur de 11,7 µm. L'angle de contact de l'eau distillée à la surface de l'article augmente de 20 % par rapport au même article non traité par la PECVD. On observe aucune délamination du film organosilicé avec les articles selon la présente invention. Le spectre IRTF du dépôt chimique montre que celui-ci est une structure essentiellement du type polysiloxane.

### Performances de résistance au feu

Les performances d'ignifugation des articles présentant ou non un dépôt organosilicé ont été évaluées en utilisant le LOI (Indice Limite d'Oxygène), le test UL94 avec des éprouvettes de 1,6 mm d'épaisseur et les mesures au calorimètre à cône.

Les résultats sont mentionnés dans le tableau suivant :

**Tableau 2**

| **Exemples** | **DESCRIPTION (% en poids par rapport au poids total)** | **LOI (%)** | **UL94 (/1,6 mm)** | **RHR (kW/m²)** | **Ignition (s)** |
|---|---|---|---|---|---|
| **C1** | PA 66 (75%) + FV (25%) | 21-22 | NC | 443 | 54 |
| **C2** | PA 66 (67%) + FV (25%) + OP1230 (8%) | 30-33 | V1 | 280 | 70 |
| **C3** | PA 66 (75%) + FV (25%) *+ dépôt PECVD* | - | NC | - | - |
| **C4** | PA 66 (92%) + OP1230 (8%) | - | NC | 400 | 60 |
| **C5** | PA 66 (92%) + OP1230 (8%) *+ dépôt PECVD* | - | NC | - | - |
| **C6** | PA 66 (90%) + OP1230 (8%) + nanocharges (2%) | - | NC | 402 | 62 |
| **C7** | PA 66 (90%) + OP1230 (8%) + nanocharges (2%) *+ dépôt PECVD* | - | NC | 325 | 65 |
| **1** | PA 66 (67%) + FV (25%) + OP1230 (8%) *+ dépôt PECVD* | 34-35 | V0 | 250 | 92 |

Le cône calorimètre est un appareil permettant entre autre d'accéder à l'évolution de la quantité de chaleur dégagée par la combustion de l'échantillon, à l'inflammabilité, la perte de masse, l'opacité des fumées et les taux de CO/CO₂ dégagés durant l'essai. L'échantillon est placé de façon horizontale et est soumis à un niveau contrôlé d'irradiance. Le test est effectué en milieu ouvert, en présence d'extracteurs. Les échantillons sont soumis, dans l'air ambiant, à un flux de chaleur émis par un cône tronqué (flux de chaleur compris entre 0 et 100 kW/m²) de manière à ne pas perturber la flamme. Le débit calorifique est évalué suivant le principe de la calorimétrie par consommation d'oxygène. Différents analyseurs couplés à ce système permettent l'évaluation de la perte de masse, de l'opacité des fumées (coefficient d'extinction k) et des taux de CO et CO₂, durant la combustion (analyseurs infrarouges). Le temps d'ignition est mesuré par ce test.

On observe ainsi que les articles ignifugés de l'invention comprenant au moins sur une partie de leurs surfaces un revêtement organo-silicé assisté par plasma froid présentent de bien meilleures propriétés d'ignifugation par rapport aux compositions polyamides ignifugées comprenant la même proportion d'agents ignifugeants. Il apparait par ailleurs que les valeurs obtenues lors des essais de chocs Charpy représentant les propriétés mécaniques desdites compositions sont équivalentes en présence ou en absence du dépôt assisté par plasma froid.

## Revendications

1. Article ignifugé obtenu par mise en forme d'une composition polyamide comprenant au moins un système d'ignifugation comprenant au moins un agent ignifugeant contenant du phosphore choisi dans le groupe constitué par les acides phosphiniques ou leurs sels; ledit article comprenant au moins sur une partie de sa surface un revêtement produit par dépôt chimique assisté par plasma froid présentant une structure inorganique de type SiO₂, et/ou une structure organique de type siloxane et/ou polysiloxane, dans lequel ladite composition comprend des charges de renfort choisies parmi les fibres de verre, les fibres de carbone et les fibres organiques.

2. Article selon la revendication 1, **caractérisé en ce que** les charges de renfort sont des fibres de verre.

3. Article selon l'une quelconque des revendications 1 à 2, **caractérisé en ce que** le système d'ignifugation de la composition polyamide comprend au moins un agent ignifugeant de type composés organiques azotés choisis dans le groupe constitué par : les triazines, l'acide cyanurique et/ou isocyanurique, la mélamine ou ses dérivés, l'oxalate, le phtalate, le borate, le sulfate, le phosphate, polyphosphate et/ou pyrophosphate de mélamine, les produits condensés de la mélamine, le tris(hydroxyéthyl) isocyanurate, la benzoguanamine, la guanidine, l'allantoïne, et le glycoluril.

4. Article selon l'une quelconque des revendications 1 à 3, **caractérisé en ce que** le système d'ignifugation de la composition polyamide comprend au moins un agent ignifugeant contenant des dérivés bromés choisis dans le groupe constitué par : les PBDPO (polybromodiphényloxydes), le BrPS (polystyrène bromé et polybromostyrène), le poly(pentabromobenzylacrylate), l'indane bromé, le tétradécabromodiphénoxybenzène, l'éthane-1,2-bis(pentabromophényl), le tétrabromobisphénol A et les oligomères époxy bromés.

5. Article selon l'une quelconque des revendications 1 à 4, **caractérisé en ce que** la composition comprend de 5 à 40 % en poids d'agents ignifugeants, par rapport au poids total de la composition.

6. Article selon l'une quelconque des revendications 1 à 5, **caractérisé en ce que** la composition comprend de 1 à 50 % en poids de charges de renfort, par rapport au poids total de la composition.

7. Article selon l'une quelconque des revendications 1 à 6, **caractérisé en ce que** le revêtement est effectué par dépôt chimique assisté par plasma froid à une température comprise entre 20 et 350°C.

8. Article selon l'une quelconque des revendications 1 à 7, **caractérisé en ce que** le revêtement est effectué par des techniques de polymérisation assistée par plasma froid, sous pression réduite ou atmosphérique.

9. Article selon l'une quelconque des revendications 1 à 8, **caractérisé en ce que** le revêtement est effectué par dépôt chimique assisté par plasma froid par PECVD -dépôt en phase vapeur assistée par plasma- (Plasma Enhanced Chemical Vapour Deposition).

10. Article selon l'une quelconque des revendications 1 à 9, **caractérisé en ce que** le revêtement à la surface de l'article présente une épaisseur comprise entre 1 et 200 µm.

11. Article selon l'une quelconque des revendications 1 à 10, **caractérisé en ce que** le revêtement à la surface de l'article présente une épaisseur comprise entre 8 et 20 µm et/ou **caractérisé en ce que** ledit article est un article extrudé ou injecté.

12. Procédé de fabrication d'article ignifugé selon l'une quelconque des revendications 1 à 11, dans lequel on applique un revêtement par dépôt chimique assisté par plasma froid sur au moins une partie de la surface de l'article obtenu par mise en forme d'une composition polyamide comprenant au moins un système d'ignifugation, en particulier après qu'une étape de traitement de la surface pour accroitre l'adhésion entre la surface et le revêtement.

## Patentansprüche

1. Feuerfester Artikel, der durch Formen einer Polyamidzusammensetzung erhalten wird, umfassend mindestens ein Flammschutzsystem, umfassend mindestens ein Flammschutzmittel, das Phosphor, ausgewählt unter den Phosphinsäuren oder ihren Salzen, enthält; wobei der Artikel mindestens auf einem Teil seiner Oberfläche eine Beschichtung umfasst, die durch durch kaltes Plasma unterstütztes chemisches Abscheiden erzeugt wird und eine anorganische Struktur des Typs SiO₂ und/oder eine organische Struktur des Typs Siloxan und/oder Polysiloxan aufweist, wobei die Zusammensetzung Verstärkungslasten umfasst, die unter den Glasfasern, den Kohlenstofffasern und den organischen Fasern ausgewählt sind.

2. Artikel nach Anspruch 1, **dadurch gekennzeichnet, dass** die Verstärkungslasten Glasfasern sind.

3. Artikel nach einem der Ansprüche 1 bis 2, **dadurch gekennzeichnet, dass** das Flammschutzsystem der Polyamidzusammensetzung mindestens ein Flammschutzmittel des Typs stickstoffhaltiger organischer Verbindungen umfasst, ausgewählt in der Gruppe, bestehend aus: den Triazinen, der Cyanid- und/oder Isocyanidsäure, dem Melamin oder seinen Derivaten, dem Oxalat, Phthalat, Borat, Sulfat, Phosphat, Polyphosphat und/oder Melamin-Pyrophosphat, den Kondensatprodukten des Melamins, dem Tris(hydroxyethyl)isocyanurat, dem Benzoguanamin, dem Guanidin, dem Allantoin und dem Glycoluril.

4. Artikel nach einem der Ansprüche 1 bis 3, **dadurch gekennzeichnet, dass** das Flammschutzsystem der Polyamidzusammensetzung mindestens ein Flammschutzmittel umfasst, das Bromderivate enthält, ausgewählt in der Gruppe, bestehend aus: den PBDPO (Polybromdiphenyloxiden), dem BrPS (bromhaltigen Polystyrol und Polybromstyrol), dem Poly(pentabrombenzylacrylat), dem bromhaltigen Indan, dem Tetradecabromdiphenoxibenzol, dem Ethan-1,2-bis(pentabromphenyl), dem Tetrabrombisphenol A und den bromhaltigen Epoxy-Oligomeren.

5. Artikel nach einem der Ansprüche 1 bis 4, **dadurch gekennzeichnet, dass** die Zusammensetzung 5 bis 40 Gew.-% Flammschutzmittel bezogen auf das Gesamtgewicht der Zusammensetzung umfasst.

6. Artikel nach einem der Ansprüche 1 bis 5, **dadurch gekennzeichnet, dass** die Zusammensetzung 1 bis 50 Gew.-% Verstärkungslasten bezogen auf das Gesamtgewicht der Zusammensetzung umfasst.

7. Artikel nach einem der Ansprüche 1 bis 6, **dadurch gekennzeichnet, dass** die Beschichtung durch durch kaltes Plasma unterstütztes chemisches Abscheiden bei einer Temperatur zwischen 20 und 350 °C erfolgt.

8. Artikel nach einem der Ansprüche 1 bis 7, **dadurch gekennzeichnet, dass** die Beschichtung durch durch kaltes Plasma unterstützte Polymerisationstechniken unter reduziertem Druck oder Luftdruck erfolgt.

9. Artikel nach einem der Ansprüche 1 bis 8, **dadurch gekennzeichnet, dass** die Beschichtung durch durch kaltes Plasma unterstützte chemische Abscheidung PECVD - durch Plasma unterstütztes Dampfabscheiden - (Plasma Enhanced Chemical Vapour Deposition) - erfolgt.

10. Artikel nach einem der Ansprüche 1 bis 9, **dadurch gekennzeichnet, dass** die Beschichtung an der Oberfläche des Artikels eine Dicke zwischen 1 und 200 µm aufweist.

11. Artikel nach einem der Ansprüche 1 bis 10, **dadurch gekennzeichnet, dass** die Beschichtung an der Oberfläche des Artikels eine Dicke zwischen 8 und 20 µm aufweist, und/oder **dadurch gekennzeichnet, dass** der Artikel ein extrudierter oder durch Spritzguss hergestellter Artikel ist.

12. Verfahren zur Herstellung eines feuerfesten Artikels nach einem der Ansprüche 1 bis 11, bei dem eine Beschichtung durch durch kaltes Plasma unterstütztes chemisches Abscheiden auf mindestens einen Teil der Oberfläche des Artikels, welcher durch Formen einer Polyamidzusammensetzung, umfassend mindestens ein Feuerschutzsystem, erhalten wird, insbesondere nach einem Schritt der Bearbeitung der Oberfläche, um die Haftung zwischen der Oberfläche und der Beschichtung zu erhöhen, aufgebracht wird.

## Claims

1. Flame-retardant article obtained by forming a polyamide composition comprising at least one flame retardant system comprising at least one phosphorus-containing flame retardant selected from the group consisting of phosphinic acids or salts thereof; said article comprising, at least over a portion of its surface, a coating produced by cold-plasma-enhanced chemical deposition having an inorganic structure of SiO₂ type, and/or an organic structure of siloxane and/or polysiloxane type, in which said composition comprises reinforcing fillers chosen from glass fibres, carbon fibres and organic fibres.

2. Article according to Claim 1, **characterized in that** the reinforcing fillers are glass fibres.

3. Article according to either one of Claims 1 and 2, **characterized in that** the flame retardant system of the polyamide composition comprises at least one flame retardant of nitrogen-containing organic compound type selected from the group consisting of: triazines, cyanuric acid and/or isocyanuric acid, melamine or derivatives thereof, melamine oxalate, phthalate, borate, sulfate, phosphate, polyphosphate and/or pyrophosphate, products condensed from melamine, tris(hydroxyethyl) isocyanurate, benzoguanamine, guanidine, allantoin and glycoluril.

4. Article according to any one of Claims 1 to 3, **characterized in that** the flame retardant system of the polyamide composition comprises at least one flame retardant containing brominated derivatives selected from the group consisting of: PBDPOs (polybromodiphenyl oxides), BrPS (polybromostyrene and brominated polystyrene), poly(pentabromobenzyl acrylate), brominated indane, tetradecabromodiphenoxybenzene, 1,2-bis(pentabromophenyl)ethane, tetrabromobisphenol A and brominated epoxy oligomers.

5. Article according to any one of Claims 1 to 4, **characterized in that** the composition comprises from 5% to 40% by weight of flame retardants, with respect to the total weight of the composition.

6. Article according to any one of Claims 1 to 5, **characterized in that** the composition comprises from 1% to 50%, by weight of reinforcing fillers, with respect to the total weight of the composition.

7. Article according to any one of Claims 1 to 6, **characterized in that** the coating is produced by cold-plasma-enhanced chemical deposition at a temperature of between 20°C and 350°C.

8. Article according to any one of Claims 1 to 7, **characterized in that** the coating is produced by cold-plasma-enhanced polymerization techniques, under reduced pressure or atmospheric pressure.

9. Article according to any one of Claims 1 to 8, **characterized in that** the coating is produced by cold-plasma-enhanced chemical deposition via PECVD (plasma-enhanced chemical vapor deposition).

10. Article according to any one of Claims 1 to 9, **characterized in that** the coating on the surface of the article has a thickness of between 1 and 200 µm.

11. Article according to any one of Claims 1 to 10, **characterized in that** the coating on the surface of the article has a thickness of between 8 and 20 µm and/or **characterized in that** said article is an extruded or injected article.

12. Process for the manufacture of a flame retardant article according to any one of Claims 1 to 11, in which a coating is applied by cold-plasma-enhanced chemical deposition over at least a portion of the surface of the article obtained by forming a polyamide composition comprising at least one flame retardant system, in particular after a surface treatment step to increase the adhesion between the surface and the coating.
